# EUROPÄISCHE PATENTSCHRIFT

(11) **EP 0 369 050 B1**
(45) Veröffentlichungstag und Bekanntmachung des Hinweises auf die Patenterteilung: **11.08.1993**
(21) Anmeldenummer: 88119044.1
(22) Anmeldetag: 15.11.1988
(51) Int. Cl.: G01S 7/52, H03K 17/16

(54) **Verfahren zur Unterdrückung von Störsignalen beim Betrieb von Ultraschall-Näherungsinitiatoren**
Method of suppression of interfering signals in the operation of an ultrasonic proximity switch
Procédé pour supprimer les signaux parasites pendant l'opération d'un commutateur de proximité à ultrasons

(43) Veröffentlichungstag der Anmeldung: 23.05.1990
(73) Patentinhaber: SIEMENS AKTIENGESELLSCHAFT, 80333 München (DE)
(72) Erfinder: Forster, Alfred, Dipl.-Ing. FH, D-8460 Schwandorf (DE); Schorner, Gerd, Dipl.-Ing. FH, D-8450 Amberg (DE)

(56) Entgegenhaltungen:
- EP-A- 0 174 090
- EP-A- 0 346 687
- FR-A- 2 394 811
- FR-A- 2 568 687
- GB-A- 2 161 932
- US-A- 4 222 275
- US-A- 4 596 144
- IEEE TRANSACTIONS ON BIOMEDICAL ENGINEERING, Band BME-27, Nr. 5, Mai 1980, Seiten 249-253, IEEE; M.S. HOSTETLER et al.: "A microprocessor-controlled echocardiographic tracking system"

## Beschreibung

Die Erfindung bezieht sich auf ein Verfahren zur Unterdrückung von Störsignalen beim Betrieb eines Ultraschall-Näherungsinitiators mit einer Steuer- und Auswerteeinheit, wobei der Ultraschall-Näherungsinitiator wiederholt Ultraschallimpulse gleicher Breite aussendet und danach am Ausgang des Ultraschall-Näherungsinitiators analoge Empfangssignale mit dem zugehörigen Nutzechosignal anstehen, die in der Steuer- und Auswerteeinheit ausgewertet werden, wobei auf Störsignale hinweisende Abweichungen des Nutzechosignals gegenüber dem ausgesendeten Ultraschallimpuls im Betrieb berücksichtigt werden.

Verfahren zur Störunterdrückung der genannten Art sind z.B. aus der DE-34 28 773 bekannt. Hier werden Fehlimpulse mittels einer Pulsbreitenmodulation eliminiert, wobei von der Bedingung ausgegangen wird, daß der Sender stets Ultraschallimpulse gleicher Breite aussendet. Fehlimpulse werden daran erkannt, daß sie schmaler oder breiter sind als die ausgesendeten Ultraschallimpulse. Dabei werden üblicherweise nur solche Impulse betrachtet, die eine zur Störgeräuschunterdrückung dienende konstante Schwelle überschreiten. Dies läßt sich mit Hilfe von Komparatoren durchführen, wie sie z.B. in dem Buch Halbleiter-Schaltungstechnik von U. Tietze, Ch. Schenk auf Seite 411 beschrieben werden.

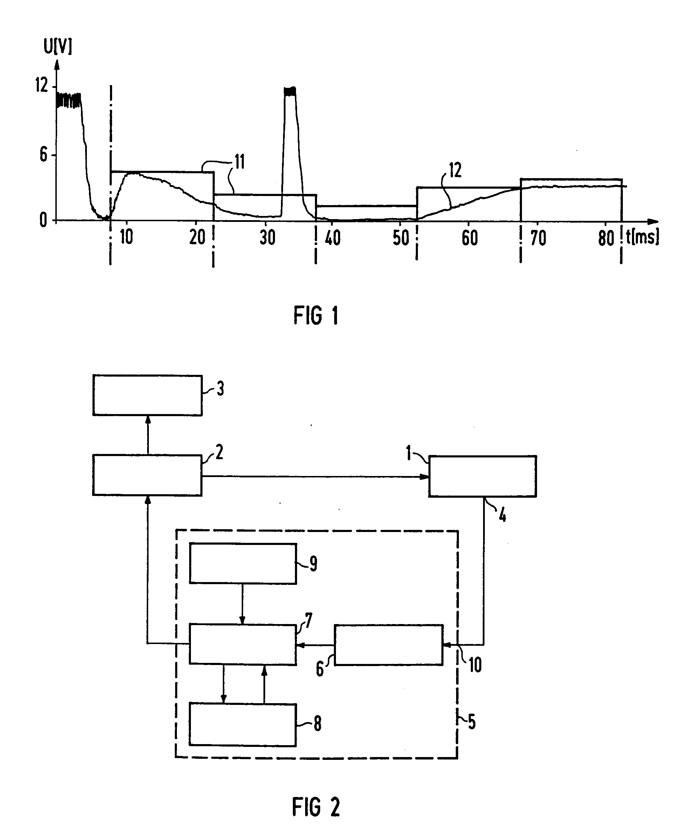

Zur Unterdrückung von stochastischen Störsignalen dient das folgende, in der nachveröffentlichten europäischen Patentanmeldung EP 0 346 687 A1 beschriebene Verfahren, das anhand des Blockschaltbildes mit der Einrichtung zur Abstandsmessung nach FIG 2 erklärt wird.

Die in FIG 2 dargestellte Einrichtung zur Ultraschall-Abstandsmessung besteht aus einem Ultraschall-Näherungsinitiator 1, einer Steuer- und Auswerteeinheit 2, einer Anzeigeeinheit 3 und einer Zwischenverarbeitungseinheit 5, die zwischen den Ultraschall-Näherungsinitiator 1 und die Steuer- und Auswerteeinheit 2 geschaltet ist. Die Zwischenverarbeitungseinheit 5 ist aus einem Analog-Digital-Wandler 6 mit integrierter Abtasteinrichtung, einem Prozessor 7, einem Datenspeicher 8 und einem Programmspeicher 9 zusammengesetzt. Der Analog-Digital-Wandler 6 liegt am Eingang 10 der Zwischenverarbeitungseinheit 5 und ist ausgangsseitig mit dem Prozessor 7 verbunden, dessen Ausgang wiederum an die Steuer- und Auswerteeinheit 2 angeschlossen ist. Der Datenspeicher 8 und der Programmspeicher 9 stehen mit dem Prozessor 7 elektrisch in Verbindung. Aufgrund der Steuerung durch die Steuer- und Auswerteeinheit 2 sendet der Ultraschall-Näherungsinitiator 1 zyklisch Ultraschallimpulse gleicher Breite aus und empfängt dazugehörige Echosignale. Das am Ausgang 4 des Ultraschall-Näherungsinitiator 1 anstehende analoge Signal wird von dem Moment ab abgetastet, in dem die Aussendung des Ultraschallimpulses beendet ist. Die Abtastung erfolgt bis zu dem das Ende des Erfassungsbereiches entsprechenden Zeitpunkt. Die Abtastung erfolgt in gleichen Zeitabschnitten. Die abgetasteten Analogwerte werden im Analog-Digital-Wandler 6 digitalisiert und an den Prozessor 7 weitergeleitet. Über den Prozessor 7 werden diese digitalisierten Abtastwerte mit den zeitäquivalenten Digitalwerten, die im Datenspeicher 8 gespeichert sind, mathematisch-logisch verknüpft. Die Zeitabstände zwischen den Abtastungen sind abhängig von der gewählten mathematisch-logischen Verknüpfungsart und den die Verknüpfung ausführenden Bauelementen. Für einfache Verknüpfungen lassen sich Zeitabstände unter z.B. 30 bis 50 µs erreichen. In dem Programmspeicher 9 ist ein Programm abgelegt, welches die im Prozessor 7 ausführende Verknüpfung steuert. Im einfachsten Fall werden die entsprechenden Digitalwerte durch eine Mittelwertbildung miteinander verknüpft, wobei die im Datenspeicher 8 gespeicherten Digitalwerte verschieden von den letzten digitalen Abtastwerten gewichtet werden können. Hierzu sei folgendes Beispiel gegeben: Der letzte Digitalabtastwert beträgt z.B. 1 und der entsprechende abgespeicherte Digitalwert z.B. 3. Beträgt dann z.B. der Wichtungsfaktor für die abgespeicherten Digitalwerte 4 und für die zuletzt abgetasteten Werte 1, so ergibt sich hieraus durch Mittelwertbildung ein neuer Wert 2.6. Die so ermittelten Digitalwerte werden anstelle der abgespeicherten Digitalwerte für entsprechende Zeitpunkte im Datenspeicher 8 abgelegt. Außerdem werden die neuen Digitalwerte von dem Prozessor 7 aus an die Steuer- und Auswerteeinheit 2 weitergeleitet. Hier werden die Digitalwerte ausgewertet, wobei der zu messende Objektabstand wie in üblicher Weise aus dem zeitlichen Abstand zwischen der Aussendung des Ultraschallimpulses und dem Empfang des zugehörigen Echosignals ermittelt wird. Zum Erkennen des Echosignals wird die bekannte Pulsbreitenauswertung vorgenommen. Darüber hinaus wird in dem erfindungsgemäßen Verfahren auch die Amplitude der Digitalwerte ausgewertet. Hierbei wird ein Grenzwert vorgegeben, der möglichst hoch, aber unterhalb der für das Echosignal gelieferten Amplitude liegt. Es werden nur die oberhalb des Grenzwertes liegenden Impulse ausgewertet und unterhalb des Grenzwertes liegende Impulse, z.B. stochastische Störsignale, unterdrückt. Auf diese Weise läßt sich das Echosignal und damit der Objektabstand mit höherer Sicherheit ermitteln.

Auch die europäische Patentanmeldung 0 174 090 bezieht sich auf die Verarbeitung von elektrischen Signalen zur Unterscheidung zwischen den interessierenden Signalkomponenten und unerwünschten Hintergrund-Störsignalen. Diese Verarbeitung bezieht sich insbesondere auf Ultraschallimpuls-Echoverfahren, bei denen die Hintergrundstörungen in großem Maße auf Nachhall-Effekte bei der Aussendung der Ultraschallimpulse durch den Sender in Verbindung mit einem durch die Elektronik bedingten elektrischen Störpegel zurückzuführen sind. Die Nachhall-Effekte begleiten das eigentliche Übertragungssignal und klingen annähernd exponentiell ab. Ihnen überlagert ist der elektrische Störpegel der Elektronik. Die Echoimpulse sind gleichfalls dem elektrischen Störpegel überlagert und müssen von den Hintergrundstörungen unterschieden werden.

Hierzu wird eine Simulationsmethode angewandt, mit der eine zeitvariable Hintergrund-Signalkomponente eines vom Wandler empfangenen Empfangssignals simuliert wird, wobei das Empfangssignal das interessierende Datensignal umfaßt, das auch störenden Hintergrundsignalen überlagert sein kann. Eine aus mehreren Schwellwerten gebildete Treppenfunktion gibt die Hintergrund-Signalkomponente wieder, die die Nachhall-Effekte und den elektrischen Störpegel der Elektronik umfaßt. Da dieses Verhalten von den wandlerspezifischen Eigenschaften abhängt, wird für jeden Wandler die zugehörige Treppenfunktion ermittelt und in digitaler Form als eine Vielzahl von Schwellwerten abgespeichert. Somit können auf obengenannte Effekte zurückzuführende Hintergrund-Signalkomponenten mit der Treppenfunktion aus dem Empfangssignal des Wandlers ausgeblendet werden.

Der Erfindung liegt die Aufgabe zugrunde, ein verbessertes Verfahren zur Unterdrückung der beim Betrieb eines Ultraschall-Näherungsinitiators auftretenden Störsignale zu schaffen, um fehlerhafte Meldungen und/oder Schalthandlungen zu vermeiden. Dies wird auf einfache Weise bei einem Verfahren der obengenannten Art dadurch erreicht, daß zunächst unter Zugrundelegung des Empfangssignals eine als Störgeräuschschwelle dienende Treppenfunktion bestimmt wird, dann durch Vergleich der Treppenfunktion mit dem Empfangssignal das zeitliche Auftreten des Nutzechosignals ermittelt wird, wodurch die vom Sendebegin an laufende Echolaufzeit des Nutzechos anschließend ermittelt werden kann, die dann an die Steuer- und Auswerteeinheit übertragen wird. Dabei bietet die Treppenfunktion als zeitabhängige Störgeräuschschwelle den Vorteil, die Störgeräusche unter Berücksichtigung ihres zeitlichen Verlaufs zu unterdrücken. Wird der abschnittsweise konstante Wert der Treppenfunktion aus dem Mittelwert des zum jeweiligen Treppenabschnitt zeitlich zugehörigen Empfangssignals unter Hinzurechnung eines von diesem Mittelwert abhängigen Störabstands gebildet, so stellt dies eine einfache Ermittlung der abschnittsweise verschiedenen Schwellwerte dar. Dabei basieren die Schwellwerte derart auf dem zeitlichen Verlauf des zum jeweiligen Zeitabschnitt zugehörigen Empfangssignals, das sie zur Unterscheidung zwischen Störgeräuschen und dem Nutzechosignal geeignet sind, d.h. z.B. zeitlich lange Signale führen im Vergleich zu kurzen zu einer starken Anhebung des Schwellwertes. Wird zur Mittelwertbildung das Empfangssignal zunächst abgetastet und nach Digitalisierung der Abtastwerte der abschnittsweise Mittelwert der Treppenfunktion aus den zeitlich zugehörigen Digitalwerten bestimmt, so ist hiermit insbesondere der Vorteil einer einfachen Abspeicherung der Digitalwerte verbunden, die zur weiteren Auswertung jederzeit verfügbar sind. Erfolgt die Abtastung in zeitäquidistanten Abständen, so erleichtert dies z.B. eine Mittelwertbildung des Empfangssignals über einen bestimmten Zeitraum. Die Wirkung des bisher geschilderten Verfahrens läßt sich weiter verbessern, wenn als Digitalwerte Speicherwerte zugrunde gelegt werden, die mit jedem Empfangssignal neu berechnet werden und die auf einer mathematisch-logischen Verknüpfung der sich zeitlich entsprechenden digitalen Abtastwerte aus den vorangegangenen Ultraschallimpulszyklen beruhen. Dieser Verfahrensschritt mindert insbesondere den verfälschenden Einfluß durch stochastische Störsignale und stellt somit eine Ergänzung zu dem mit zeitabhängiger Schwelle arbeitenden Verfahren dar, durch das vor allem die störende Einwirkung von Dauergeräuschen reduziert wird. Zur Durchführung des obengenannten Verfahrens ist der Ultraschall-Näherungsinitiator nach Anspruch 6 besonders entwickelt.

In der Zeichnung ist ein Ausführungsbeispiel der Erfindung dargestellt, das im folgenden näher beschrieben ist.

Es zeigen:
- FIG 1: den zeitlichen Verlauf eines Empfangssignals und einer Treppenfunktion 11 als Störgeräuschschwelle,
- FIG 2: das Blockschaltbild mit der Einrichtung zur Ultraschallabstandsmessung,
- FIG 3: das Ablaufdiagramm des Verfahrens.

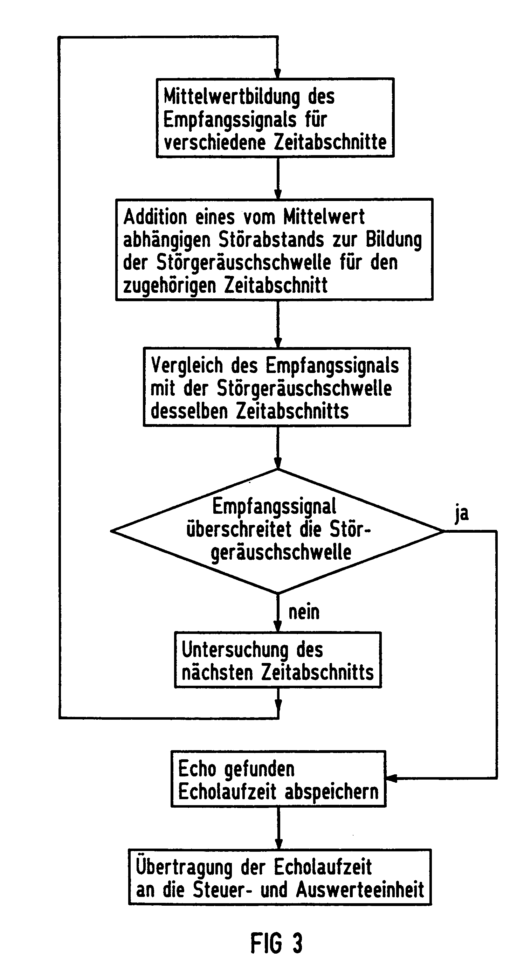

Zur Unterdrückung von Störsignalen, z.B. Regen und Rauschen, ist es bei der Ultraschall-Abstandsmessung zweckmäßig, das nach Aussendung eines Ultraschall-Impulses empfangene Nutzecho unter Zugrundelegung einer zeitabhängigen Schwelle, z.B. einer Treppenfunktion 11, zu erfassen. Die am Ultraschallwandler anliegende Spannung infolge des Empfangssignals hat z.B. den in FIG 1 durch die Linie 12 dargestellten Verlauf. Zum Zeitpunkt t = 0 beginnt der Sendeimpuls, der nach etwa 5 ms am Ende der Schwingungsanregung abzuklingen beginnt und auf nahezu 0 sinkt. Diesem schließt sich in der genannten Reihenfolge als Empfangssignal ein zunächst durch Regen bedingtes Störsignal, das Nutzechosignal und anschließend ein Rauschsignal an. Die Störsignale, die unterhalb der Treppenfunktion 11 liegen, werden unterdrückt und ermöglichen somit, das Nutzecho als kurzen Empfangsimpuls eindeutig zu erfassen, wie es im Ablaufdiagramm des Verfahrens nach FIG 3 verdeutlicht wird. Zur Durchführung dieses Ermittlungsverfahrens wird das auf den Sendeimpuls folgende Empfangssignal zunächst abgetastet und die Abtastwerte nach ihrer Digitalisierung gespeichert. Eine Abtastung in gleichen Zeitabständen läßt sich einfach verwirklichen und erleichtert außerdem das anschließende Auswerteverfahren. Die abgespeicherten Digitalwerte werden mit den zeitäquivalenten Werten einer Treppenfunktion 11 als Störgeräuschschwelle verglichen. Der Vergleich zeigt das Nutzechosignal und damit auch seine gesuchte Laufzeit, ausgehend vom Beginn des Sendeimpulses, auf, die dann zur Abstandsermittlung nach bekannten Methoden ausgewertet wird. Um auch Nutzechosignale mit einem im Vergleich zu Störgeräuschen niedrigeren Pegel im Empfangssignal erfassen zu können, ist die Treppenfunktion 11 mit abschnittsweise konstanten Schwellen gemäß FIG 1 besonders vorteilhaft. Aus den gespeicherten Digitalwerten wird jeweils der Mittelwert eines Zeitabschnitts gebildet, aus dem sich unter Hinzurechnung eines Störabstands der für den jeweiligen Zeitabschnitt gültige Schwellwert ergibt. Dabei kann der Störabstand abschnittsweise verschieden sein und z.B. von dem betreffenden Mittelwert des Zeitabschnitts abhängen. Im Hinblick auf sich zeitlich langsam ändernde Störsignale erscheint es sinnvoll, bei hohem Mittelwert einen kleinen Störabstand und bei vergleichsweise kleinem Mittelwert einen höheren Störabstand zu wählen.

Die bisher beschriebenen Maßnahmen dienen insbesondere zur Unterdrückung der störend wirkenden Dauergeräusche im Empfangssignal.

Das Blockschaltbild in FIG 2 ist auch gültig für das mit zeitabhängiger Schwelle arbeitende Verfahren zur Unterdrückung vor allem von Dauergeräuschen, bei dem jedes Empfangssignal für sich ausgewertet wird. Hierbei werden die am Ausgang des Analog-Digital-Wandlers 6 mit Abtasteinrichtung anstehenden Digitalwerte über den Prozessor 7, der noch mit dem Programmspeicher 9 in Verbindung steht, zum Datenspeicher 8 zur dortigen Abspeicherung übertragen. Nach einem im Programmspeicher 9 abgelegten Programm wird im Prozessor 7 geprüft, welche der im Datenspeicher 8 abgespeicherten digitalen Abtastwerte des Empfangssignals die zeitäquivalenten Werte einer zeitabhängigen Störgeräuschschwelle überschreiten. Die Störgeräuschschwelle kann dabei beispielsweise eine Treppenfunktion 11 sein, wie in FIG 1 dargestellt.

Die zeitabhängige Störgeräuschschwelle in Form einer Treppenfunktion 11 errechnet der Prozessor aus den abgespeicherten Digitalwerten nach einem Programm im Programmspeicher 9, indem er aus den Digitalwerten jedes Zeitabschnitts z.B. den zugehörigen Mittelwert bildet und zu diesem einen Störabstand addiert. Der Störabstand kann als eine vom Mittelwert abhängige Größe im Prozessor 7 zu bestimmen sein oder z.B. auch als Konstante im Datenspeicher 8 vorgegeben sein.

Durch Verquickung des stochastische Störsignale unterdrückenden Verfahrens mit dem Verfahren zur Ausblendung vor allem von Dauergeräuschen läßt sich bei Vorhandensein und Störgeräuschen im Empfangssignal das gesuchte Nutzecho am zuverlässigsten ermitteln. Im Gegensatz zu dem zuvor beschriebenen Verfahren zur Unterdrückung von Dauergeräuschen werden hier nicht die digitalen Abtastwerte des jeweils zuletzt empfangenen Echosignals ausgewertet. Diese werden stattdessen zunächst - wie für das stochastische Störsignale unterdrückende Verfahren beschrieben - mathematisch-logisch mit den abgespeicherten Digitalwerten, die aus der Verknüpfung von vorangegangenen Echosignalen bestimmt wurden, verknüpft, bevor sie nach dem oben beschriebenen, Dauergeräusche unterdrückenden Verfahren mit einer zeitabhängigen Störgeräuschschwelle verglichen werden. Hieraus ergibt sich die Echolaufzeit des Nutzechos, aus der dann in bekannter Weise der zugehörige Abstand des Meßobjekts ermittelt werden kann.

## Patentansprüche

1. Verfahren zur Unterdrückung von Störsignalen beim Betrieb eines Ultraschall-Näherungsinitiators (1) mit einer Steuer- und Auswerteeinheit (2), wobei der Ultraschall-Näherungsinitiator (1) wiederholt Ultraschallimpulse gleicher Breite aussendet und danach am Ausgang des Ultraschall-Näherungsinitiators (1) analoge Empfangssignale mit dem zugehörigen Nutzechosignal anstehen, die in der Steuer- und Auswerteeinheit (2) ausgewertet werden, wobei auf Störsignale hinweisende Abweichungen des Nutzechosignals gegenüber dem ausgesendeten Ultraschallimpuls im Betrieb berücksichtigt werden, **dadurch gekennzeichnet,** daß zunächst unter Zugrundelegung des Empfangssignals eine als Störgeräuschschwelle dienende Treppenfunktion (11) bestimmt wird, dann durch Vergleich der Treppenfunktion (11) mit dem Empfangssignal das zeitliche Auftreten des Nutzechosignals ermittelt wird, wodurch die vom Sendebeginn an laufende Echolaufzeit des Nutzechos anschliessend ermittelt werden kann, die dann an die Steuer und Auswerteeinheit (2) übertragen wird.

2. Verfahren nach Anspruch 1, **dadurch gekennzeichnet,** daß der abschnittsweise konstante Wert der Treppenfunktion (11) aus dem Mittelwert des zum jeweiligen Treppenabschnitt zeitlich zugehörigen Empfangssignals unter Hinzurechnung eines von diesem Mittelwert abhängigen Störabstands gebildet wird.

3. Verfahren nach Anspruch 2, **dadurch gekennzichnet,** daß zur Mittelwertbildung das Empfangssignal zunächst abgetastet wird und nach Digitalisierung der Abtastwerte der abschnittsweise Mittelwert der Treppenfunktion (11) aus den zeitlich zugehörigen Digitalwerten bestimmt wird.

4. Verfahren nach Anspruch 3, **dadurch gekennzeichnet,** daß die Abtastung in zeitäquidistanten Abständen erfolgt.

5. Verfahren nach Anspruch 3 oder 4, **dadurch gekennzeichnet,** daß als Digitalwerte Speicherwerte zugrunde gelegt werden, die mit jedem Empfangssignal neu berechnet werden und die auf einer mathematisch logischen Verknüpfung der sich zeitlich entsprechenden digitalen Abtastwerte aus den vorangegangenen Ultraschallimpulszyklen beruhen.

6. Ultraschall-Näherungsinitiator (1) zur Durchführung des Verfahrens nach Anspruch 1 mit einer Steuer- und Auswerteeinheit (2), wobei der Ultraschall-Näherungsinitiator (1) wiederholt Ultraschallimpulse gleicher Breite aussendet und danach am Ausgang des Ultraschall-Näherungsinitiators (1) analoge Empfangssignale mit dem dazugehörigen Nutzechosignal anstehen, die in der Steuer- und Auswerteeinheit (2) ausgewertet werden, wobei auf Störsignale hinweisende Abweichungen des Nutzechosignals gegenüber dem ausgesendeten Ultraschallimpuls im Betrieb berücksichtigt werden, **dadurch gekennzeichnet,**
daß zwischen Ausgang (4) des Ultraschall-Näherungsinitiators (1) und der Steuer- und Auswerteeinheit (2) eine Zwischenverarbeitungseinheit (5) geschaltet ist, bestehend aus einer Abtasteinrichtung, einem Analog-Digital-Wandler (6), einem Prozessor (7), einem Datenspeicher (8) und einem Programmspeicher (9), wobei der Analog-Digital-Wandler (6) zwischen den Ausgang (4) und den Prozessor (7) geschaltet ist, der sowohl mit dem Programmspeicher (9), dem Datenspeicher (8) und der Steuer- und Auswerteeinheit (2) elektrisch verbunden ist, wobei die Abtasteinrichtung zur Abtastung des analogen Empfangssignals dient, wobei der Analog-Digital-Wandler (6) aus den Abtastwerten Digitalwerte bildet, wobei der Datenspeicher (8) zur Abspeicherung der Digitalwerte dient, wobei der Prozessor zur Bestimmung einer zeitabhängigen Störgeräuschschwelle in Form einer Treppenfunktion (11) aus den abgespeicherten Digitalwerten nach einem Programm im Programmspeicher und zur anschließenden Ermittlung des zeitlichen Auftretens des Nutzechosignals durch Vergleich der Treppenfunktion mit dem Empfangssignal dient.

## Claims

1. Method for the suppression of interference signals during the operation of an ultrasonic proximity switch (1) having a control and evaluation unit (2), the ultrasonic proximity switch (1) repeatedly transmitting ultrasonic pulses of equal width, after which analog reception signals are produced with the associated usable echo signal at the output of the ultrasonic proximity switch (1), which reception signals are evaluated in the control and evaluation unit (2), with deviations in the usable echo signal relative to the transmitted ultrasonic pulse, indicating interference signals, being taken into account in operation, characterised in that a step function (11) serving as an interference noise threshold is first determined on the basis of the reception signal, then the occurrence in time of the usable echo signal is determined by comparison of the step function (11) with the reception signal, by which means the echo transit time of the usable echo from the beginning of transmission can subsequently be determined, which echo transit time is then transmitted to the control and evaluation unit (2).

2. Method according to claim 1, characterised in that the value of the step function (11), which is constant for each section, is formed from the mean value of the reception signal temporally associated with the respective step section, summed with a noise ratio dependent on this mean value.

3. Method according to claim 2, characterised in that, for forming the mean value, first the reception signal is scanned and, after digitizing of the scanned values, the mean value of the step function (11), for each section, is determined from the temporally associated digital values.

4. Method according to claim 3, characterised in that the scanning takes place at equal time intervals.

5. Method according to claim 3 or 4, characterised in that stored values are used as a basis for digital values, which stored values are newly calculated with each reception signal and are based on a mathematical logic operation of the temporally corresponding digital scanned values, from the preceding ultrasonic pulse cycles.

6. Ultrasonic proximity switch (1) for carrying out the method according to claim 1, having a control and evaluation unit (2), the ultrasonic proximity switch (1) repeatedly transmitting ultrasonic pulses of equal width, after which analog reception signals are produced with the associated usable signal at the output of the ultrasonic proximity switch (1), which reception signals are evaluated in the control and evaluation unit (2), with deviations in the usable echo signal relative to the transmitted ultrasonic pulse, indicating interference signals, being taken into account in operation, characterised in that, between the output (4) of the ultrasonic proximity switch (1) and the control and evaluation unit (2), there is connected an intermediate processing unit (5) comprising a scanning device, an analog-to-digital converter (6), a processor (7), a data memory (8) and a program memory (9), the analog-to-digital converter (6) being connected between the output (4) and the processor (7), which is electrically connected to the program memory (9), the data memory (8) and the control and evaluation unit (2), the scanning device serving to scan the analog reception signal, the analog-to-digital converter (6) forming digital values from the scanned values, the data memory (8) serving for storing the digital values, the processor serving for determining a time-dependent noise ratio threshold in the form of a step function (11) from the stored digital values according to a program in the program memory and for subsequently determining the occurrence in time of the usable echo signal by comparing the step function with the reception signal.

## Revendications

1. Procédé pour supprimer des signaux parasites lors du fonctionnement d'un déclencheur de proximité à ultrasons (1) comportant une unité de commande et d'évaluation (2), selon lequel le déclencheur de proximité à ultrasons (1) émet de façon répétée des impulsions ultrasonores de même durée, et ensuite (1) apparaissent des signaux de réception analogiques ainsi que le signal d'écho utile associé, ces signaux étant évalués dans l'unité de commande et d'évaluation (2), à la sortie du déclencheur de proximité à ultrasons, et des écarts du signal d'écho utile, qui indiquent des signaux parasites, par rapport à l'impulsion ultrasonore émise sont pris en compte pendant le fonctionnement, caractérisé par le fait que tout d'abord, en prenant pour base le signal d'entrée, on détermine une fonction en escalier (11), qui est utilisée en tant que seuil de bruit parasite, puis on détermine, en comparant la fonction en escalier (11) au signal de réception, l'apparition dans le temps du signal d'écho utile, ce qui permet de déterminer ensuite le temps de propagation de l'écho utile, qui est compté à partir du début de l'émission et qui est alors transmis à l'unité de commande et d'évaluation (2).

2. Procédé suivant la revendication 1, caractérisé par le fait que la valeur, qui est constante par intervalles, de la fonction en escalier (11) est formée par la valeur moyenne du signal de réception associé dans le temps à la section respective de l'escalier, moyennant l'addition d'une marge de protection qui dépend de cette valeur moyenne.

3. Procédé suivant la revendication 2, caractérisé par le fait que pour la formation de la valeur moyenne, on échantillonne tout d'abord le signal de réception et, après numérisation des valeurs échantillonnées, on détermine la valeur moyenne par intervalles de la fonction en escalier (11) à partir des valeurs numériques associées dans le temps.

4. Procédé suivant la revendication 3, caractérisé par le fait que l'échantillonnage s'effectue à des intervalles équidistants dans le temps.

5. Procédé suivant la revendication 3 ou 4, caractérisé par le fait qu'on utilise, en tant que valeurs numériques, des valeurs en mémoire, qui sont à nouveau calculées pour chaque signal de réception et qui sont basées sur une combinaison logique mathématique des valeurs d'échantillonnage numériques, qui se correspondent dans le temps, tirées des cycles précédents d'impulsions ultrasonores.

6. Déclencheur de proximité à ultrasons (1) pour la mise en oeuvre du procédé suivant la revendication 1, comportant une unité de commande et d'évaluation (2), selon lequel le déclencheur de proximité à ultrasons (1) émet de façon répétée des impulsions ultrasonores de même durée, et ensuite (1) apparaissent des signaux de réception analogiques ainsi que le signal d'écho utile associé, ces signaux étant évalués dans l'unité de commande et d'évaluation (2), à la sortie du déclencheur de proximité à ultrasons, et des écarts du signal d'écho utile, qui indiquent des signaux parasites, par rapport à l'impulsion ultrasonore émise sont pris en compte pendant le fonctionnement, caractérisé par le fait qu'entre la sortie (4) du déclencheur de proximité à ultrasons (1) et l'unité de commande et d'évaluation (2) est branchée une unité de traitement intermédiaire (5), qui est constituée par un dispositif d'échantillonnage, un convertisseur analogique/numérique (6), un processeur (7), une mémoire de données (8) et une mémoire de programmes (9), que le convertisseur analogique/numérique (6) est branché entre la sortie (4) et le processeur (7), qui est raccordé électriquement à la mémoire de programmes (9), à la mémoire de données (8) et à l'unité de commande et d'évaluation (9), que le dispositif d'échantillonnage sert à échantillonner le signal de réception analogique, que le convertisseur analogique/numérique (6) forme des valeurs numériques à partir des valeurs d'échantillonnage, que la mémoire de données (8) sert à mémoriser des valeurs numériques, que le processeur sert à déterminer un seuil de bruit parasite, qui dépend du temps, sous la forme d'une fonction en escalier (11) à partir des valeurs numériques mémorisées, conformément à un programme situé dans la mémoire de programmes, et à déterminer ultérieurement l'apparition dans le temps du signal d'écho utile, par comparaison de la fonction en escalier au signal de réception.
